# EUROPÄISCHE PATENTSCHRIFT

(11) **EP 0 718 973 B1**
(45) Veröffentlichungstag und Bekanntmachung des Hinweises auf die Patenterteilung: **19.09.2001**
(21) Anmeldenummer: 94120271.5
(22) Anmeldetag: 21.12.1994
(51) Int. Cl.: H03K 5/1534

(54) **Flankendetektor**
Transition detector
Détecteur de transition

(43) Veröffentlichungstag der Anmeldung: 26.06.1996
(73) Patentinhaber: TEXAS INSTRUMENTS DEUTSCHLAND GMBH, 85350 Freising (DE)
(72) Erfinder: Kiml, Helmut, D-84184 Tiefenbach (DE)
(74) Vertreter: Schwepfinger, Karl-Heinz, Dipl.-Ing.

(56) Entgegenhaltungen:
- US-A- 4 259 601
- PATENT ABSTRACTS OF JAPAN vol. 12, no. 9 (E-572) (2856) 12. Januar 1988 & JP-A-62 169 514 (MITSUBISHI ELECTRIC CORP) 25. Juli 1987

## Beschreibung

Die Erfindung bezieht sich auf einen Flankendetektor zum Erzeugen von Ausgangssignalen in Abhängigkeit von positiven und negativen Flanken eines Rechteck-Eingangssignals gemäß dem Oberbegriff des Patentanspruchs.

Aus PATENT ABSTRACTS OF JAPAN, vol. 12, no. 9 (E-572) (2856) 12. Januar 1988 & JP-A-62 169 514 (MITSUBISHI ELECTRIC CORP) 25. Juli 1987 ist bereits ein solcher Flankendetektor bekannt. In diesem bekannten Flankendetektor wird vor allem angestrebt, bei beiden Flanken des Rechtecksignals am Ausgang genau den gleichen Signalverlauf mit gleicher Amplitude zu erzielen, wobei unter Inkaufnahme eines relativ hohen Schaltungsaufwands zusätzlich zum Differenzverstärker ein Ausgangskomparator zum Einsatz kommt, dem an einem Eingang stets eine Referenzspannung zugeführt werden muß.

Ein für die Verwendung des eingangs geschilderten Flankendetektors geeigneter Differenzverstärker ist aus der US 4 259 601 bekannt. Dieser Differenzverstärker wird in einem Komparator verwendet, der an seinem Ausgang immer dann ein Signal abgibt, wenn der Betrag seines Eingangssignals kleiner als eine intern erzeugte Referenzspannung ist.

Die Übertragung von Datensignalen über Busse wird in immer größerem Umfang angewendet. In einem Bus-System sind dabei an den Bus mehrere elektronische Geräte angeschlossen, die vom Bus Datensignale empfangen oder zum Bus Datensignale senden können. Damit die Kommunikation zwischen den einzelnen Geräten fehlerfrei stattfinden kann, ist es wichtig, daß die Geräte jeweils den Beginn und das Ende eines Datensignals, das üblicherweise ein Rechtecksignal ist, sicher erkennen. Zu diesem Zweck kann ein Flankendetektor eingesetzt werden, der immer dann ein Signal abgibt, wenn an den Bus eine Signalflanke, also entweder eine ansteigende oder eine abfallende Signalflanke auftritt. Der Flankendetektor könnte beispielsweise von einem Komparator gebildet sein, der den Signalpegel an der Busleitung mit einem festen Referenzsignal vergleicht und immer dann ein Flankenerkennungssignal abgibt, wenn der Signalpegel am Bus den Referenzsignalpegel überschreitet oder unterschreitet.

In einem Bussystem kann es jedoch vorkommen, daß es aufgrund von Einstreuung zu einer Verschiebung des Massepegels kommt, die so weit gehen kann, daß das Erkennen einer Signalflanke durch einen einfachen Vergleich mit einem Referenzsignal nicht mehr möglich ist. Der Massepegel kann sich nämlich unter Umständen so weit verschieben, daß er in die Nähe des Referenzsignalpegels kommt, wobei dann eine eindeutige Flankenerkennung nicht mehr möglich ist.

Der Erfindung liegt die Aufgabe zugrunde, einen Flankendetektor zu schaffen, der ohne großen Schaltungsaufwand eine sichere Erkennung der Flanken von Signalen ermöglicht, die auf einen Bus übertragen werden.

Erfindungsgemäß wird diese Aufgabe mit den im kennzeichnenden Teil des Patentanspruchs 1 angegebenen Merkmalen gelöst.

Beim erfindungsgemäßen Flankendetektor wird zum Erkennen der Signalflanken des angelegten Eingangssignals kein eigener Referenzpegel benötigt, sondern es wird stets der Eingangssignalpegel mit einem im Flankendetektor zwischengespeicherten Pegel verglichen, der dem Pegel entspricht, der am Eingang vor dem Auftreten der jeweils zu erkennenden Flanke vorhanden war. Es erfolgt somit eine ständige automatische Anpassung an den jeweils am Eingang vorhandenen Signalpegel, so daß auch bei einer Verschiebung des Massepegels der Flankendetektorschaltung noch eine einwandfreie Erkennung der Signalflanken möglich ist.

Ein Ausführungsbeispiel der Erfindung wird nun unter Bezugnahme auf die Zeichnung erläutert. In der Zeichnung zeigen:
Fig. 1 ein Schaltbild des erfindungsgemäßen Flankendetektors und
Fig. 2 Diagramme von Signalen an verschiedenen Punkten der Schaltung von Fig. 1.

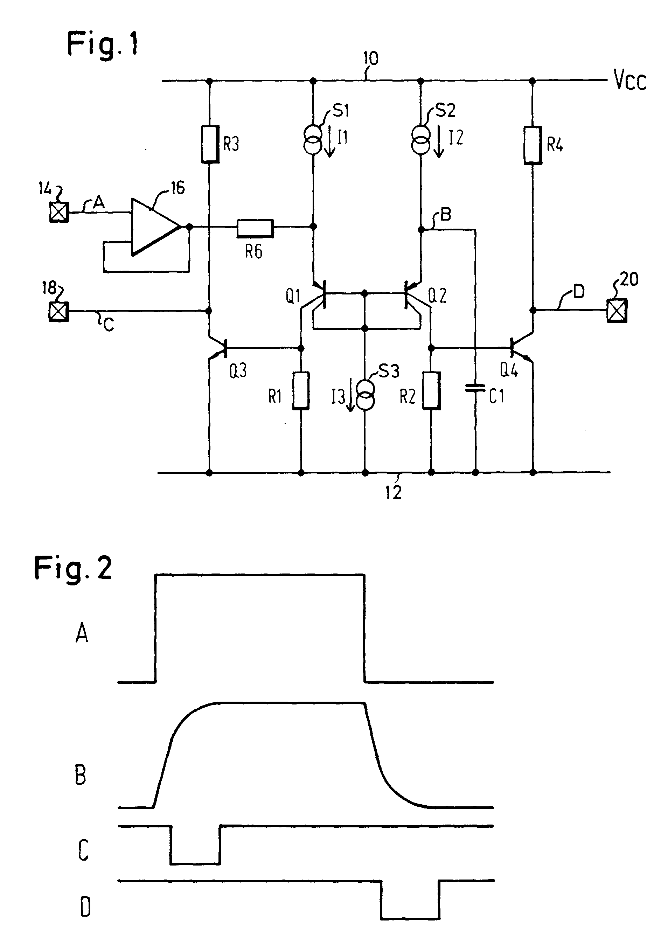

Der in Fig. 1 dargestellte Flankendetektor enthält einen Differenzverstärker aus zwei basisgekoppelten Transistoren Q1 und Q2, deren Emitter über eine Konstantstromquelle S1 bzw. S2 an eine Versorgungsspannungsleitung 10 angeschlossen sind, an der eine positive Versorgungsspannung Vcc liegt. Die Stromquellen S1 und S2 liefern jeweils Gleichströme I1 bzw. I2.

Die Basis-Anschlüsse der beiden Transistoren Q1 und Q2 sind miteinander und über eine dritte Stromquelle S3 mit einer Masseleitung 12 verbunden. Wie zu erkennen ist, haben die Transistoren Q1 und Q2 jeweils zwei Kollektor-Anschlüsse, von denen die ersten über einen Widerstand R1 bzw. R2 mit der Masseleitung 12 verbunden sind, während die anderen miteinander, mit den Basis-Anschlüssen und über die Stromquelle S3 mit der Masseleitung 12 verbunden sind.

Die Emitterströme der Transistoren Q1 und Q2 werden jeweils zur Hälfte auf die beiden Kollektoren aufgeteilt, so daß jeweils eine Hälfte des Emitterstroms durch die Widerstände R1 bzw. R2 und die andere Hälfte durch die Stromquelle S3 fließt. Somit gilt: I3 = I1/2 + I2/2. Da die Ströme I1 und I2 gleich sind, bedeutet dies, daß gilt: I3 = I1 = I2.

Das Eingangssignal, dessen Flanken erkannt werden sollen, wird an einen Eingang 14 angelegt, von dem aus es über einen als Impedanzwandler wirkenden Operationsverstärker 16 und einen Widerstand R6 zum Emitter des Transistors Q1 gelangt.

Zwischen dem Emitter des Transistors Q2 und der Masseleitung 12 liegt ein Kondensator C1, der als Speicherkondensator dient, wie noch zu erkennen sein wird.

Der Flankendetektor von Figur 1 weist zwei Ausgänge 18 und 20 auf, an dem ein eine positive Flanke des Eingangssignals anzeigendes Ausgangssignal bzw. ein eine negative Flanke des Eingangssignals anzeigendes Ausgangssignal abgegeben werden. Das Ausgangssignal am Ausgang 18 wird durch einen NPN-Transistor Q3 erzeugt, dessen Basis mit dem zweiten Kollektor des Transistors Q1 verbunden ist. Der Emitter dieses Transistors Q3 ist mit der Masseleitung 12 verbunden. Der Kollektor ist mit dem Ausgang 18 verbunden, und er ist über einen Widerstand R3 mit der Versorgungsspannungsleitung 10 verbunden.

Das Ausgangssignal am Ausgang 19 wird von einem NPN-Transistor Q4 erzeugt, dessen Basis mit dem zweiten Kollektor des Transistors Q2 verbunden ist. Der Emitter dieses Transistors Q4 ist mit der Masseleitung 12 verbunden, und sein Kollektor ist mit dem Ausgang 20 und über einen Widerstand R4 mit der Versorgungsspannungsleitung 10 verbunden.

Der Flankendetektor von Figur 1 arbeitet wie folgt:

Es sei angenommen, daß der Eingang 14 mit einem der Übertragung von Datensignalen dienenden Bus verbunden ist, und daß sich der Bus gerade im Leerlaufzustand befindet, also kein Datensignal vorhanden ist. Dies bedeutet, daß am Bus eine Leerlaufspannung vorhanden ist, die zwischen dem Massepegel und der positiven Versorgungsspannung Vcc liegt. In diesem Ruhezustand liegt am Emitter des Transistors Q1 die gleiche Spannung wie am Eingang 14, und aufgrund des Differenzverstärkerverhaltens der beiden Transistoren Q1 und Q2 stellt sich auch am Emitter des Transistors Q2 diese Eingangsspannung ein. Durch die beiden Kollektoren der Transistoren Q1 und Q2 fließt jeweils der halbe Wert des Stroms I1 bzw. I2, so daß demgemäß auch durch die Widerstände R1 und R2 jeweils die Ströme I1/2 bzw. I2/2 fließen. Diese Ströme erzeugen an den Widerständen R1 und R2 Spannungsabfälle, die kleiner als die Basis-Emitter-Spannung der Transistoren Q₃ und Q₄ sind, so daß sich diese Transistoren im gesperrten Zustand befinden, was bedeutet, daß an den Ausgängen 18 und 20 jeweils die Spannung Vcc auftritt, die dem Signalwert "H" entspricht. Wenn nun, wie bei A in Figur 2 gezeigt, am Eingang 14 die positive Flanke eines Datensignals auftritt, entsteht am Widerstand R6 ein Spannungsabfall, der dazu führt, daß der Emitter des Transistors Q1 einen zusätzlichen Emitterstrom empfängt. Zum Emitter dieses Transistors Q1 fließt somit die Summe des Stroms aus der Stromquelle S1 und des Stroms vom Eingang 14. Dieser erhöhte Strom teilt sich auf die beiden Kollektoren des Transistors Q1 auf, so daß auch durch den Widerstand R1 ein erhöhter Strom fließt. Wenn das Datensignal genügend groß ist, also über einem bestimmten Pegel liegt, dann reicht der durch den Spannungsabfall am Widerstand R6 hervorgerufene Strom durch den Widerstand R1 aus, um infolge des an diesem Widerstand auftretenden Spannungsabfall den Transistor Q3 durchzuschalten. Dies tritt ein, wenn der Spannungsabfall am Widerstand R1 größer als die Basis-Emitter-Spannung des Transistors Q1 ist. Wenn der Transistor Q1 durchschaltet, geht das Signal am Ausgang 18 auf einen niedrigen Wert über, der dem Signalwert "L" entspricht. Dies bedeutet, daß die beschriebene Schaltung nur dann auf ein Datensignal am Eingang 14 reagiert, wenn dieses Signal einen bestimmten Schwellenwert überschreitet.

Der erhöhte Emitterstrom des Transistors Q1 hat auch zur Folge, daß durch den mit der Stromquelle S3 verbundenen Kollektor ein größerer Strom fließt. Da die Stromquelle S3 aber nur einen Strom ableiten kann, der dem Strom I1 entspricht, bedeutet dies, daß der Strom verringert werden muß, der durch den mit der Stromquelle S3 verbundenen Kollektor des Transistors Q2 fließt. Die gleiche Erniedrigung des Stroms tritt auch im zweiten Kollektor des Transistors Q2 auf, so daß der Transistor Q4 weiterhin im gesperrten Zustand verbleibt. Da die Stromquelle S2 nach wie vor den Strom I2 liefert, muß der überschüssige Strom, der nicht mehr von der Stromquelle S2 abgeleitet werden kann, in den Kondensator C1 fließen und diesen aufladen. Dieses Aufladen kann aber nur so lange fortgesetzt werden, bis am Emitter des Transistors Q2 die gleiche Spannung wie am Emitter des Transistors Q1 erreicht ist. Sobald dies der Fall ist, können in den Transistoren Q1 und Q2 keine unterschiedlichen Ströme mehr fließen, so daß sich hinsichtlich der Ströme wieder der gleiche Zustand einstellt, der vor dem Auftreten des Eingangssignals vorgeherrscht hat. Dies bedeutet, daß durch den Widerstand R1 und den Widerstand R2 jeweils genau die Hälfte der Ströme I1 bzw. I2 fließen. Der Transistor Q3 geht daher wieder in den gesperrten Zustand über, da der Spannungsabfall am Widerstand R1 nicht mehr ausreicht, ihn durchzuschalten. Dies ist in Figur 2 bei C zu erkennen. Die Dauer des am Ausgang 18 auftretenden Impulses, der das das Auftreten der positiven Flanke des Eingangssignals anzeigende Signal ist, wird durch die Zeitkonstante aus dem Widerstand R6 und dem Kondensator C1 bestimmt.

Aus Figur 2 ist zu erkennen, daß die Spannung am Punkt B entsprechend der Zeitkonstanten aus dem Widerstand R6 und dem Kondensator C1 ansteigt, wenn am Eingang 14 ein Eingangssignal der bei A in Figur 2 dargestellten Form auftritt. Ferner ist zu erkennen, daß das Ausgangssignal am Ausgang 18 nur während der Zeitdauer vorhanden ist, von der sich die Spannung am Punkt B ändert, der Aufladevorgang des Kondensators C1 also noch nicht abgeschlossen ist. Das Ausgangssignal am Ausgang 18 endet also dann, wenn der Kondensator C1 aufgeladen ist, die Spannung am Punkt B also den Wert der Eingangsspannung am Eingang 14 und somit den Wert der Spannung am Emitter des Transistors Q1 erreicht hat.

Beim Auftreten der negativen Flanke des Eingangssignals am Eingang 14 wird über den Widerstand R6 der Emitterstrom des Transistors Q1 verringert, was zu einer Verringerung des durch den mit der Stromquelle S3 verbundenen Kollektor fließenden Stroms führt. Da der Strom durch die Stromquelle S3 aber konstantgehalten wird, muß der zusätzliche Strom über den Emitter des Transistors Q2 zugeführt werden. Da die Stromquelle S2 nur den konstanten Strom I2 liefern kann, ergibt sich der zusätzliche Emitterstrom des Transistors Q2 durch das Entladen des Kondensators C1. In Figur 2 ist bei B dieser Entladevorgang dargestellt, der nach Auftreten der negativen Signalflanke am Eingang 14 einsetzt. Der erhöhte Emitterstrom des Transistors Q2 hat auch die Erhöhung des Stroms durch den Widerstand R2 zur Folge, der zu einem größeren Spannungsabfall am Widerstand R2 führt. Dadurch wird der Transistor Q4 durchgeschaltet, so daß am Ausgang 20 ein Übergang auf einen niedrigen Spannungswert erfolgt, der dem Signalwert "L" entspricht. Dies ist in Figur 2 bei D dargestellt.

Sobald der Entladevorgang des Kondensators C1 beendet ist, stellt sich am Emitter des Transistors Q2 die gleiche Spannung wie am Emitter des Transistors Q1 ein, und das Fließen unterschiedlicher Emitterströme in diesen Transistoren endet. Dadurch fließt auch durch den Widerstand R2 wieder der Strom I2/2, der nicht ausreicht, am Widerstand R2 einen Spannungsabfall hervorzurufen, der größer als die Basis-Emitter-Spannung des Transistors Q4 ist. Dieser Transistor Q4 wird daher wieder gesperrt, so daß die Spannung am Ausgang 20 wieder den Versorgungsspannungswert Vcc annimmt, der dem Signalwert "H" entspricht. Dies ist in Figur 2 bei D zu erkennen.

Die beschriebene Schaltung kann somit mit großer Sicherheit am Eingang 14 auftretende Signalflanken erkennen, ohne daß dazu ein fester Referenzpegel benötigt wird. Der Flankendetektor erkennt vielmehr die Signalflanke als Abweichung von dem vor Auftreten der Flanke vorhandenen Spannungswert am Eingang 14, der jeweils im Kondensator C1 gespeichert ist. Diese Flankenerkennung arbeitet auch dann noch einwandfrei, wenn das Massepotential aufgrund von Störsignaleinstreuungen oder aufgrund anderer Effekte zu höheren Spannungswerten hin verschoben worden ist.

## Patentansprüche

1. Flankendetektor zum Erzeugen von Ausgangssignalen in Abhängigkeit von positiven und negativen Flanken eines Rechteck-Eingangssignals, mit einem Differenzverstärker mit zwei basisgekoppelten Transistoren (Q1, Q2) und einem Kondensator (C1) zum adaptiven Speichern einer Spannung am Differenzverstärker, **dadurch gekennzeichnet, daß** die Emitter der beiden Transistoren (Q1, Q2) jeweils über eine erste bzw. eine zweite Konstantstromquelle (S1, S2) mit einer Versorgungsspannungsleitung (10) verbunden sind, wobei ihre Emitterströme jeweils auf zwei Kollektoren aufgeteilt sind, von denen die ersten miteinander und über eine dritte Konstantstromquelle (S3) mit Masse (12) verbunden sind, daß zwei Ausgangszweige des Differenzverstärkers jeweils eine Serienschaltung aus einem Widerstand (R3, R4) und der Kollektor-Emitter-Strecke eines Ausgangstransistors (Q3, Q4) zwischen Masse (12) und der Versorgungsspannungsleitung (10) enthalten, daß bei jedem dieser Ausgangstransistoren (Q3, Q4) die Basis mit jeweils einem zweiten Kollektor der basisgekoppelten Transistoren (Q1, Q2) verbunden ist, so daß der Schaltzustand der Ausgangstransistoren (Q3, Q4) von der Spannung am jeweiligen zweiten Kollektor bestimmt wird, daß die Ausgangssignale am Kollektor dieser Ausgangstransistoren (Q3, Q4) abgreifbar sind, daß ein Eingangsanschluß (14) vorgesehen ist, der zur Einspeisung eines vom Eingangssignal abhängigen Stroms mit dem Emitter eines (Q1) der basisgekoppelten Transistoren (Q1, Q2) verbunden ist, und daß der Kondensator (C1) mit dem Emitter des anderen (Q2) der basisgekoppelten Transistoren (Q1, Q2) verbunden ist.

## Claims

1. An edge detector for the production of output signals in a manner dependent on positive and negative edges of a square wave signal, comprising a differential amplifier with two base-coupled transistors (Q1, Q2) and a capacitor (C1) for adaptive storage of a voltage at the differential amplifier, **characterized in that** the emitters of the two transistors (Q1, Q2) are each connected via a first and, respectively, a second constant current source (S1, S2) with a supply voltage line (10), and whose emitter currents are each split up between two collectors, of which the first ones are connected with each other and via a third constant current (S3) with ground (12), two output loops each having a series circuit arrangement comprising a resistor (R3, R4) and the collector-emitter path of an output transistor (Q3, Q4) between ground (12) and the supply voltage line (10), and in the case of each of these output transistors (Q3, Q4) the base is connected with a respective second collector of the base-coupled transistors (Q1, Q2) so that the switching state of the output transistors (Q3, Q4) is set by the voltage at the respective second collector and the output signals at the collector of such output transistors (Q3, Q4) are able to be tapped, an output terminal (14) being provided, which for the supply of a current dependent on the input signal is connected with the emitter of one (Q1) of the base-coupled transistors (Q1, Q2), and that the capacitor (C1) is connected with the emitter of the other one (Q2) of the base-coupled transistors (Q1, Q2).

## Revendications

1. Détecteur de flancs pour produire des signaux de sortie en fonction de flancs positif et négatif d'un signal d'entrée rectangulaire, comportant un amplificateur différentiel possédant deux transistors (Q1,Q2) couplés par leurs bases, et un condensateur (C1) pour réaliser la mémorisation adaptative d'une tension aux bornes de l'amplificateur différentiel, **caractérisé en ce que** les émetteurs des transistors (Q1,Q2) sont reliés à une ligne de tension d'alimentation (10), chacun par l'intermédiaire d'une première ou d'une seconde source de courant constant (S1,S2), leurs courants d'émetteur étant répartis respectivement entre deux collecteurs, dont les premiers sont reliés entre eux et, par l'intermédiaire d'une troisième source de courant constant (S3), à la masse (12), que deux branches de sortie de l'amplificateur différentiel contiennent chacune un circuit série formé d'une résistance (R3,R4) et de la voie collecteur-émetteur d'un transistor de sortie (Q3,Q4), entre la masse (12) et la ligne de tension d'alimentation (10), que dans chacun de ces transistors de sortie (Q3,Q4), la base est reliée respectivement à un second collecteur des transistors (Q1,Q2) couplés par leurs bases, de sorte que l'état de commutation des transistors de sortie (Q3,Q4) est déterminé par la tension présente sur le second collecteur respectif, que les signaux de sortie peuvent être prélevés sur le collecteur de ces transistors de sortie (Q3,Q4), qu'il est prévu une borne d'entrée (14) qui, pour l'alimentation d'un courant qui dépend du signal d'entrée, est reliée à l'émetteur de l'un (Q1) des transistors (Q1,Q2) couplés par leurs bases, et que le condensateur (C1) est relié à l'émetteur de l'autre (Q2) des transistors (Q1,Q2) couplés par leurs bases.
